Europäisches Patentamt

European Patent Office

Office européen des brevets

(19)

(11) Veröffentlichungsnummer : **0 021 203**
**B1**

(12) **EUROPÄISCHE PATENTSCHRIFT**

(45) Veröffentlichungstag der Patentschrift :
13.10.82

(51) Int. Cl.³ : **H 01 L 27/14**

(21) Anmeldenummer : **80103171.7**

(22) Anmeldetag : **06.06.80**

(54) Integrierte Serien-Solarzellenanordnung.

(30) Priorität : **15.06.79 DE 2924177**

(43) Veröffentlichungstag der Anmeldung :
**07.01.81 (Patentblatt 81/01)**

(45) Bekanntmachung des Hinweises auf die Patenterteilung : **13.10.82 Patentblatt 82/41**

(84) Benannte Vertragsstaaten :
**AT CH FR GB IT LI NL SE**

(56) Entgegenhaltungen :
**DE C 649 335**
**FR A 2 400 261**

(73) Patentinhaber : **Fraunhofer-Gesellschaft zur Förderung der angewandten Forschung e.V.**
**Leonrodstrasse 54**
**D-8000 München 19 (DE)**

(72) Erfinder : **Goetzberger, Adolf, Dr. Prof.**
**Friedhofstrasse 13**
**D-7802 Merzhausen (DE)**

(74) Vertreter : **Kraus, Walter, Dr.**
**Patentanwälte Dres. Kraus & Weisert Irmgardstrasse
15**
**D-8000 München 71 (DE)**

## Integrierte Serien-Solarzellenanordnung

Die Erfindung betrifft eine integrierte Solarzellenanordnung gemäß dem Oberbegriff des Anspruches 1.

### 1. Problemstellung

Solarzellen liefern bekanntlich eine Spannung, die durch die Bandlücke des verwendeten Halbleiters begrenzt ist, im Regelfall etwa 50 bis 80 % der Bandlücke. Siliziumsolarzellen liefern z.B. bei einer Si-Bandlücke von 1.1 eV eine Leerlaufspannung von etwa 0.6 V. Diese niedrige Spannung der Solarzellen ist in der Praxis außerordentlich hinderlich, da für jede mögliche Anwendung eine höhere Spannung gefordert wird, d.h. man muß immer eine Reihe von Solarzellen hintereinanderschalten. Das mühselige Verschalten jeder einzelnen Zelle verursacht einen erheblichen Anteil der Kosten des Gesamtsystems.

In der vorliegenden Erfindung soll eine Solarzellenstruktur beschrieben werden, die in integrierter Form die Serienschaltung von vielen Zellen auf einem Substrat ermöglicht. Dadurch könnte man für viele Anwendungen mit nur einer Solarzelle auskommen und für größere Anlagen den Verschaltungsaufwand wesentlich herabsetzen.

### 2. Stand der Technik

Es sind bereits einige Vorschläge bekannt, wie man eine monolithische Serienschaltung von Zellen erreichen kann, die sich jedoch alle wegen technischer Schwierigkeiten bisher nicht durchsetzen konnten.

In der US-PS 39 94 012 wird eine Anordnung beschrieben, bei der auf einem isolierenden Substrat eine dünne Schicht aus einkristallinem Halbleitermaterial angeordnet ist, in welcher eine Anzahl Solarzellen mit p-n-Übergängen bildenden, senkrecht zu der Halbleitersubstratebene aufgebauten Halbleiterzonenfolgen in einer Reihe und in Abständen voneinander parallel zur Halbleitersubstratebene angeordnet und durch auf der Halbleiterschicht aufgebrachte, die Halbleiterzonen kontaktierenden Leiterbahnen in Serie geschaltet sind. Die Realisierung dieser Struktur ist technologisch möglich für Halbleitermaterialien mit hohem Absorptionskoeffizient für die umzuwandelnde elektromagnetische Strahlung, d.h. für Halbleiter mit direkter Bandstruktur, für die eine geringe Schichtdicke des Materials von einigen µm ausreicht. Große technologische Schwierigkeiten ergeben sich bei indirekten Halbleitermaterialien, zu denen auch das Silizium gehört, welche zur ausreichenden Absorption der Strahlung eine Schichtdicke von mindestens 50 µm, besser aber mehr als 100 µm aufweisen müssen. Um diese bekannte Solarzelle zu realisieren, muß nämlich an den Verknüpfungsstellen eine hochdotierte Zone von der Oberfläche der Halbleiterschicht bis zur zuunterst liegenden p-oder n-Schicht geschaffen werden. Nach dem heutigen Stand der Technik kann dies nur durch Diffusion der p- oder n-Dotierung erfolgen, wobei die Diffusion durch derartige Schichtdicken äußerst zeitaufwendig ist. Eine besondere Schwierigkeit ergibt sich auch dadurch, daß die Diffusion nicht nur in Richtung senkrecht, zur Substratebene verläuft, sondern daß die hochdotierte Zone sich auch gleichmäßig nach beiden Seiten horizontal ausbreitet, was zu einem erheblichen Platzbedarf für $n^+$- oder $p^+$-Zonen führt. Da diese Fläche nicht zur aktiven Solarzelle gehört, wird der Umwandlungswirkungsgrad erheblich vermindert.

Eine weitere Solarzelle, die in diesem Zusammenhang wichtig ist, die « interdigitated solar cell », die in IEEE Transactions on Electron Devices, Vol. ED-24, 1977, No. 4, der Seiten 337 bis 342, beschrieben ist. Sie beruht auf der Erkenntnis, daß in hochohmigem Halbleitermaterial die durch die Bestrahlung im Gleichgewicht erzeugte Ladungsträgerdichte höher ist als die von der Dotierung herrührende. Durch nebeneinander eindiffundierte $p^+$- und $n^+$-Zonen erfolgt eine Trennung der photogenerierten Ladungsträger, so daß die Photospannung zwischen diesen Zonen abgenommen werden kann. Voraussetzung für das Funktionieren der Solarzellenanordnung ist, daß die Schichtdicke des Halbleiters und die Entfernung der hochdotierten Zonen voneinander nicht größer ist als die Diffusionslänge der Ladungsträger. Sie kann allerdings nicht direkt zur Serienschaltung verwendet werden, da daraus nur Kurzschlüsse resultieren würden.

Aus der DE-C 64 93 35 ist eine integrierte Solarzellenanordnung bekannt, bei der an den beiden Oberflächen des Halbleitersubstrates mehrere nicht zusammenhängende lichtdurchlässige Metallstreifen angebracht sind, derart, daß bei Belichtung eine Hintereinanderschaltung gegeben ist.

### 3. Beschreibung der integrierten Serien-Solarzelle

Aufgabe der Erfindung ist es, eine integrierte Solarzellenanordnung gemäß dem Oberbegriff des Patentanspruches 1 zu schaffen, die trotz erheblicher Dicke des Halbleitermaterials nur das Einbringen sehr dünner dotierter Zonen erfordert und die durch Leiterbahnen an der Oberfläche die Verschaltung zur monolithischen Serienzelle ermöglicht.

Die erfindungsgemäße Anordnung ist in Anspruch 1 gekennzeichnet, vorteilhafte Ausgestaltungen der Erfindung sind in den Unteransprüchen 2-6 aufgeführt. Das Einbringen von Störniveaus in eine Anordnung nach Anspruch 3 ist in Anspruch 7 angegeben.

Figur 1 zeigt das Entstehen der Serien-Solarzelle aus diskreten, hintereinander geschalteten Einzelzellen (1a). In 1b sind die Einzelzellen so rotiert, daß die Verknüpfung auf jeweils einer Seite möglich ist. In 1c ist schließlich diese Struktur monolithisch mit aufgedampften Leiterbahnen realisiert.

Figur 2 zeigt die elektrische Separation der Einzelzellen durch geätzte Gräben.

Figur 3 zeigt die Separation durch Dotierung mit Störtermen (schraffierte Bereiche). Die Störterme können entweder durch Elektronenbestrahlung oder Diffusion eingebracht werden.

Figur 4 zeigt die Separierung durch nichtkontaktierte $n^+$- und $p^+$-Zonen.

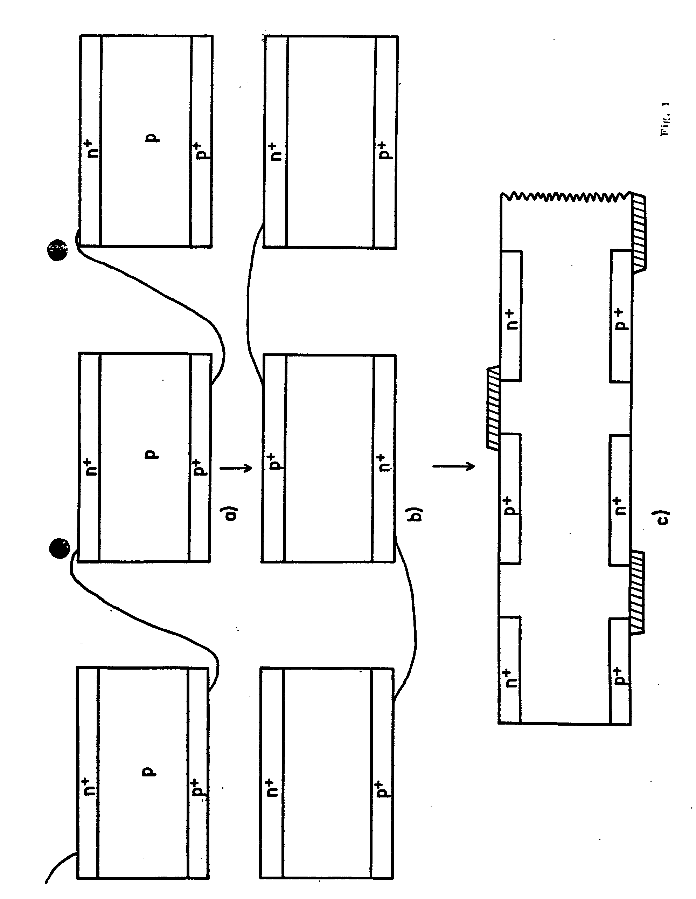

.In Fig. 1 ist gezeigt, wie aus der Serienschaltung von einzelnen Solarzellen eine integrierte Solarzelle entsteht. Man stellt sich die $n^+p$ $p^+$-Zellen abwechselnd umgedreht vor und vereinigt diese Anordnung zu einer monolithischen Struktur mit Metallkontakten, die die Serienschaltung bewirken. Diese Strukturen funktionieren dann, wenn das Substrat — die Zone zwischen $p^+$ und $n^+$ — möglichst hochohmig ist, so daß im Betriebsfall die durch Licht erzeugten Ladungsträger eine höhere Konzentration als die aus der Dotierung resultierenden haben. Es ist außerdem vorauszusetzen, daß die Dicke der Solarzelle kleiner ist als die Ladungsträgerdiffusionslänge. Wie aus Fig. 1 zu ersehen ist, hat die integrierte Solarzelle auch den Vorteil, daß sie entweder nur von einer Seite oder von beiden Seiten beleuchtet werden kann. Das ist insbesondere von Vorteil für die Anwendung in Fluoreszenzkollektoren.

Nun hat aber die integrierte Solarzelle, wie sie in Fig. 1 dargestellt ist, einen Nachteil : Zwischen jeweils zwei nicht durch Metallkontakte verknüpften $p^+$- und $n^+$-Zonen liegt die doppelte Spannung, die in einer einzelnen Zelle erzeugt wird, in Flußrichtung. Dadurch fließt ein Injektionsstrom zwischen den beiden Zonen, der als parasitärer Strom dem Nutzstrom entgegenfließt. Daher müssen Maßnahmen getroffen werden, um diese Zonen elektrisch zu separieren. Da die kritischen Bereiche von den Anregungsstrahlen mit erfaßt werden, entsteht dadurch die normale Photospannung zwischen den Oberflächenzonen, die der Injektionsspannung entgegengesetzt ist, so daß die effektive Injektionsspannung gleich der einer einzelnen Solarzelle ist.

Mehrere Wege können begangen werden, um die Separation zu erzielen. Diese sollen nun kurz beschrieben werden.

### 3.1. Ätzung von Separationsgräben

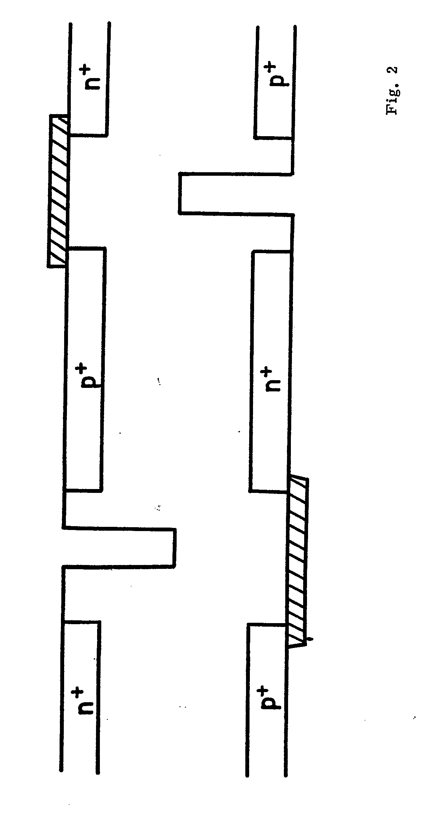

In Fig. 2 ist gezeigt, wie durch geeignete geätzte Einschnitte zwischen den Zellenbereichen die Injektionsströme eleminiert werden . können. Wegen der vorhin erwähnten Gegenspannung genügt es, die Gräben durch das halbe Substrat zu ätzen. Dadurch bleibt die mechanische Stabilität der Serien-Solarzelle erhalten. Die hier beschriebene Ätzung kann mit den heute bekannten Methoden der Halbleitertechnologie bewerkstelligt werden, z.B. mit kristallanisotroper Ätze oder Plasmaätzung. Durch die nur teilweise Durchätzung des Substrates bleibt die Integrität des Bauelements erhalten.

### 3.2. Dotierung mit Rekombinationszentren bzw. Traps

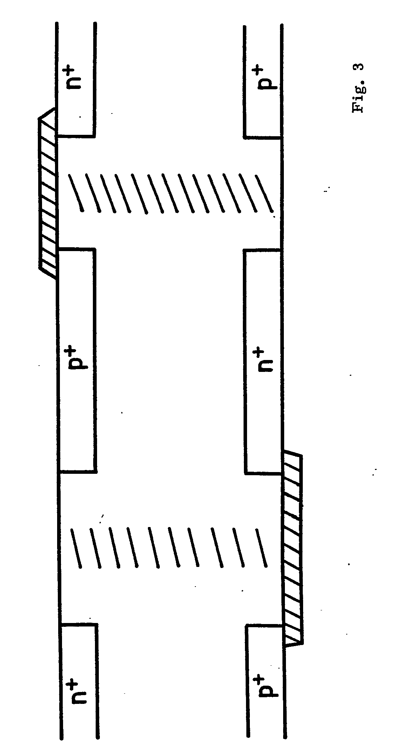

Eine einfache, wenn auch nicht ganz so effektive Separation kann durch Dotierung mit Rekombinationszentren bzw. Traps erreicht werden (Fig. 3). Bekanntlich ist in perfekten p-n-Übergängen der Strom bei vorherrschender Trägerinjektion $I = I_0 e^{qV/kT}$ gegeben ($I_0$ = Sperrstrom, V = anliegende Spannung). Wenn Raumladungsrekombination vorherrscht, wird diese Beziehung $I = I_0 e^{qV/kT}$, d.h. der Exponentialfaktor ist um den Faktor 2 reduziert. Zusammen mit der Photogegenspannung erhält man daher einen kleineren parasitären Strom. Die eingebrachten Störterme sollten mehr als Traps denn als Rekombinationszentren wirken. Eine sehr einfache Methode zur Einbringung der Störterme bietet Bestrahlung mit Elektronenstrahlen. Die Separation von Einzelkomponenten integrierter Schaltungen durch Rekombinationszentren ist an sich aus der GB-PS 10 52 857 bekannt. Das dort beschriebene Verfahren kommt aber aus zwei Gründen für die hier betrachtete Anwendung nicht in Frage :

1. Gold oder andere Rekombinationszentren sind für Solarzellen außerordentlich schädlich, da sich die Diffusionslängen reduzieren. Es ist erfahrungsgemäß nicht möglich, die Diffusion dieser Rekombinationszentren auf einen engen Bereich zu beschränken. Daher sollten hier die eingebrachten Zentren nicht als Rekombinationszentren wirken, sondern als tiefe Traps, was durch stark unterschiedliche Einfangquerschnitte für Elektronen bzw. Löcher bewirkt wird.

2. Aus den bereits oben erwähnten Gründen würde eine Diffusion der Störstellen einen zu hohen Flächenbedarf erfordern.

### 3.3. Schutzringe

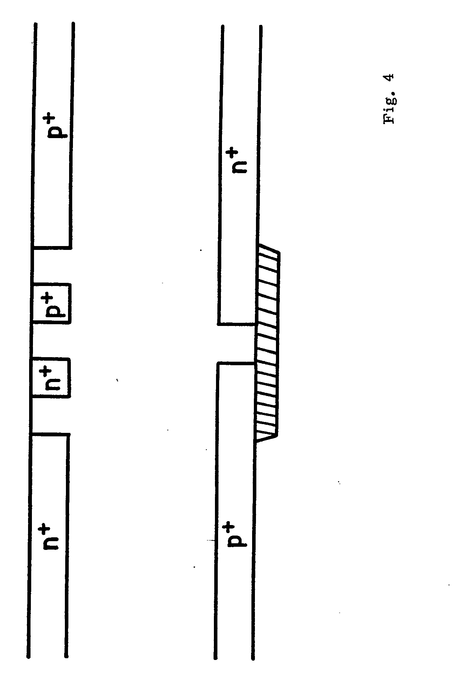

Eine weitere Methode, um den vorgenannten Zweck zu erreichen, besteht in der Anordnung von nichtkontaktierten Zwischenzonen ($p^+$ oder $n^+$). Dadurch wird die Spannung unterteilt und ebenfalls der Injektionsstrom reduziert (Fig. 4). Die Anwendung von Schutzringen in der integrierten Schaltungstechnik ist zwar bekannt (siehe z.B. Papers of the 24th Electronic Components Conf. Wash. USA, 1974, S. 262), wird dort aber nur für Zwecke des Channelstops verwendet. Auf hochohmigen Substraten vom p-Typ bilden sich häufig unerwünschte Inversionsschichten vom n-Typ, die durch derartige $p^+$-Zonen unterbrochen werden können.

### 4. Anwendung und Ausführungsformen

Die Anwendung der integrierten Serien-Solarzellen kann sowohl als Flachzellen als auch als Konzentratorzellen geschehen. Die hauptanwendung wird jedoch in Konzentratoren gesehen. Die hier beschriebene Solarzelle hat den besonderen Vorteil, daß sie auf beiden Seiten lichtempfindlich ausgestaltet werden kann, da sie eine diesbezügliche symmetrische Struktur darstellt. Dadurch kann sie vorteilhaft für konzentrierende Systeme eingesetzt werden. Diese können konventioneller Art sein (FR-OS 23 42 558) oder als Fluoreszenzkollektoren (Appl. Phys., Vol. 14, 1977, S. 123) ausgebildet sein.

**Ansprüche**

1. Integrierte Solarzellenanordnung, bei der in einem Halbleitersubstrat eine Anzahl von Solarzellen mit PN-Übergängen bildenden, senkrecht zur Halbleitersubstratebene aufgebauten Halbleiterzonenfolgen in Abständen voneinander und in einer Reihe parallel zur Halbleitersubstratebene angeordnet und durch auf dem Halbleitersubstrat angebrachte, die Halbleiterzonen kontaktierenden Leiterbahnen in Serie geschaltet sind, dadurch gekennzeichnet, daß an den beiden Oberflächen eines hochohmigen Halbleitersubstrates je eine Reihe von streifenförmigen, zueinander parallelen, voneinander Abstände aufweisenden, abwechselnd $p^+$- und $n^+$-leitenden Halbleiterzonen derart angeordnet sind, daß jeweils einer $p^+$-leitenden Halbleiterzone an der einen Oberfläche des Halbleitersubstrates eine $n^+$-leitende Halbleiterzone an der anderen Oberfläche gegenüberliegt, und daß abwechselnd auf der einen und der anderen Oberfläche des Halbleitersubstrats Leiterbahnen angeordnet sind, die je eine Solarzellen-Zonenfolge mit einer benachbarten in Serienschaltung verbinden.

2. Anordnung nach Anspruch 1, dadurch gekennzeichnet, daß die nicht durch Leiterbahnen verknüpften Zonen durch Spalte im Substrat separiert sind, deren Tiefe mindestens die halbe Dicke des Substrats beträgt.

3. Anordnung nach Anspruch 1, dadurch gekennzeichnet, daß zwischen die nicht durch Leiterbahnen verknüpften Zonen tiefe Störstellenniveaus eingebracht werden.

4. Anordnung nach Anspruch 1, dadurch gekennzeichnet, daß zwischen den nicht durch Leiterbahnen verknüpften $p^+$- und $n^+$-Zonen schmale, nicht elektrisch verbundene $n^+$- und/oder $p^+$-Zonen angeordnet sind.

5. Anordnung nach einem der Ansprüche 1 bis 4, dadurch gekennzeichnet, daß als Halbleiter Silizium verwandt wird.

6. Anordnung nach einem der Ansprüche 1 bis 5, dadurch gekennzeichnet, daß sie in Verbindung mit einem Fluoreszenzkollektor angewandt wird.

7. Verfahren zum Einbringen von Störstellenniveaus für eine Anordnung nach Anspruch 3, dadurch gekennzeichnet, daß es durch Elektronenbestrahlung erfolgt.

**Claims**

1. An integrated solar cell arrangement in which a number of solar cells with semiconductor zone sequences forming PN-junctions and built up perpendicularly of the plane of a semiconductor substrate are arranged at intervals from one another and in a row parallel to said plane in said semiconductor substrate and are connected in series by conductor paths arranged on the semiconductor substrate and contacting the semiconductor zones, characterised in that the two surfaces of a highly resistive semiconductor substrate each have arranged on them a row or strip-like, alternately $p^+$- and $n^+$-conducting semiconductor zones arranged parallel to one another at intervals apart, in such a way that an $n^+$-conducting semiconductor zone on one surface of the semiconductor substrate faces a $p^+$-conducting semiconductor zone on the other surface and in that conductor paths each connecting a solar cell zone sequence to an adjacent solar cell zone sequence are alternately arranged on one surface and the other surface of the semiconductor substrate.

2. An arrangement as claimed in Claim 1, characterised in that the zones which are not connected by conductor paths are separated by gaps in the substrate of which the depth corresponds to at least half the thickness of the substrate.

3. An arrangement as claimed in Claim 1, characterised in that deep imperfection levels are introduced between the zones which are not connected by conductor paths.

4. An arrangement as claimed in Claim 1, characterised in that narrow electrically non-connected $n^+$- and/or $p^+$-zones are arranged between the $p^+$- and $n^+$-zones which are not connected by conductor paths.

5. An arrangement as claimed in any of Claims 1 to 4, characterised in that silicon is used as the semiconductor.

6. An arrangement as claimed in any of Claims 1 to 5, characterised in that it is used in conjunction with a fluorescence collector.

7. A method of introducing impurity levels for an arrangement of the kind claimed in Claim 3, characterised in that it is carried out by electronic irradiation.

**Revendications**

1. Matrice intégrée de cellules solaires, sur laquelle un certain nombre de cellules solaires, qui comportent des successions de zones de semi-conducteurs formant des jonctions PN et disposées perpendiculairement au plan du substrat des semi-conducteurs, sont disposées dans un substrat de semi-conducteurs, à une certaine distance les unes des autres et en une série, parallèlement au plan du substrat de semi-conducteurs, ces cellules solaires étant connectées en série par des voies conductrices disposées sur le substrat de semi-conducteurs et se trouvant en contact avec les zones de semi-conducteurs, laquelle matrice est caractérisée en ce qu'une série de zones de semi-conducteurs en forme de bandes parallèles entre elles, comportant des intervalles entre elles et alternativement p⁺ et n⁺ conductrices, sont disposées sur les deux surfaces d'un substrat de semi-conducteurs à résistance élevée, de telle manière qu'une zone de semi-conducteurs p⁺ conductrice qui se trouve sur l'une des surfaces du substrat de semi-conducteurs, fait face, sur l'autre surface à une zone de semi-conducteurs n⁺ conductrice et que, des voies conductrices qui relient chaque fois une succession de zones de cellules solaires à un montage en série voisin, sont disposées alternativement sur l'une et l'autre surfaces du substrat de semi-conducteurs.

2. Matrice suivant la revendication 1, caractérisée en ce que les zones qui ne sont pas reliées par des voies conductrices sont séparées par des fentes pratiquées dans le substrat et dont la profondeur correspond au moins à la demi-épaisseur du substrat.

3. Matrice suivant la revendication 1, caractérisée en ce que des niveaux de pièges profonds sont disposés entre les zones qui ne sont pas reliées par des voies conductrices.

4. Matrice suivant la revendication 1, caractérisée en ce que des zones n⁺ et/ou p⁺ étroites, non connectées électriquement, sont disposées entre les zones p⁺ et n⁺ qui ne sont pas reliées par des voies conductrices.

5. Matrice suivant l'une quelconque des revendications 1 à 4, caractérisée en ce qu'on utilise du silicium comme semi-conducteur.

6. Matrice suivant l'une quelconque des revendications 1 à 5, caractérisée en ce qu'elle est utilisée en combinaison avec un collecteur à fluorescence.

7. Procédé pour l'introduction des niveaux de pièges destinés à une matrice conforme à la revendication 3, caractérisé en ce qu'elle est réalisée par rayonnement électronique.

a)

b)

c)

Fig. 1

n+    p+    n+

p+    n+    p+

Fig. 2

Fig. 3

Fig. 4